# EUROPEAN PATENT APPLICATION

(11) **EP 4 468 377 A1**
(43) Date of publication of application: **27.11.2024**
(21) Application number: 24175603.0
(22) Date of filing: 14.05.2024
(51) Int. Cl.: H01L 33/50, C09K 11/77, H01L 33/56, H01L 33/60

(54) **LIGHT-EMITTING DEVICE**

(30) Priority: 25.05.2023 JP 2023086221
(71) Applicant: Nichia Corporation, Anan-shi, Tokushima 774-8601 (JP)
(72) Inventor: HAYASHI, Yusuke, Anan-shi, Tokushima (JP); SHICHIJO, Satoshi, Anan-shi, Tokushima (JP); FUKUTA, Hiroki, Anan-shi, Tokushima (JP)
(74) Representative: Betten & Resch

(57) **Abstract**

A light-emitting device includes a light-emitting element configured to emit a first light, a wavelength conversion member disposed on an upper surface of the light-emitting element and configured to emit, by excitation by the first light, a second light having a peak wavelength longer than a peak wavelength of the first light, and a covering member disposed around the light-emitting element and the wavelength conversion member and containing a light-reflective material and a phosphor. The phosphor is configured to emit, by excitation by the first light, a third light having a peak wavelength longer than the peak wavelength of the second light. The content of the phosphor above the upper surface of the light-emitting element is less than the content of the phosphor below the upper surface of the light-emitting element.

## Description

### CROSS-REFERENCE TO RELATED APPLICATION

This application claims priority to Japanese Patent Application No. 2023-086221, filed on May 25, 2023, the disclosure of which is hereby incorporated by reference in its entirety.

### TECHNICAL FIELD

The present disclosure relates to a light-emitting device.

### BACKGROUND

In recent years, a light-emitting device using a light-emitting element such as a light-emitting diode has been widely used. As an example, Japanese Patent Publications No. 2020-161773 and No. 2010-219324 disclose a light-emitting device including a light-emitting element that emits light of a predetermined wavelength, a wavelength conversion member disposed on the light-emitting element, and a covering member that surrounds the light-emitting element and contains a phosphor.

However, in the light-emitting devices disclosed in the Japanese Patent Publications No. 2020-161773 and No. 2010-219324, there is a room for improvement in terms of how the phosphor is contained in the covering member.

### SUMMARY

According to the inventors' research, it has been found that light emission characteristics of light-emitting devices are improved by improving how a phosphor in the light-emitting devices is contained. Based on the perspective, an object of the present disclosure is to improve the light emission characteristics of a light-emitting device.

A light-emitting device of the present disclosure includes a light-emitting element configured to emit a first light, a wavelength conversion member disposed on an upper surface of the light-emitting element and configured to emit, by excitation by the first light, a second light having a peak wavelength longer than a peak wavelength of the first light, and a covering member disposed around the light-emitting element and the wavelength conversion member in a top view and containing a light-reflective material and a phosphor. The phosphor is configured to emit, by excitation by the first light, a third light having a peak wavelength longer than the peak wavelength of the second light. A content of the phosphor above the upper surface of the light-emitting element is less than a content of the phosphor below the upper surface of the light-emitting element.

A light-emitting device of the present disclosure can improve the light emission characteristics of the light-emitting device.

### BRIEF DESCRIPTION OF DRAWINGS

FIG. 1 schematically illustrates a cross-sectional view of a light-emitting device according to an embodiment of the present disclosure.
FIG. 2 schematically illustrates a cross-sectional view of a light-emitting device according to another embodiment of the present disclosure.
FIG. 3 is a graph showing particle size distributions of phosphors.
FIG. 4 is a graph showing evaluation results of a first demonstration test.
FIG. 5 is another graph showing evaluation results of the first demonstration test.
FIG. 6 is a graph showing evaluation results of a second demonstration test.
FIG. 7 is a table showing evaluation results of a third demonstration test.

### DETAILED DESCRIPTIONS

Hereinafter, embodiments for implementing the present disclosure are described with reference to the drawings. However, the light-emitting device to be described below is merely for embodying technical concepts of the present disclosure, and the present disclosure is not limited to the following description unless specifically stated.

In each drawing, members having identical functions may be denoted by the same reference characters. In consideration of explanation of main points or ease of understanding, a plurality of embodiments may be illustrated separately for convenience. Partial substitutions or combinations of configurations shown in different embodiments are possible. In the embodiments to be described below, descriptions of matters common to those already described may be omitted, and only different features may be described. In particular, similar effects or advantages of similar configurations shall not be mentioned each time for individual embodiments. The size, positional relationship, and other features of members illustrated in the drawings may be exaggerated in order to clarify explanation. As a cross-sectional view, an end view illustrating only a cut surface may be used.

In the following description, terms indicating specific directions or positions (e.g., "upper", "upward," "lower", "downward", and other terms including or related to those terms) may be used. However, these terms are only used to indicate relative directions or positions in the referenced drawing. For example, on the assumption that there are two members, the positional relationship expressed as "on, upper, or lower" in the present disclosure may include a case in which the two members are in contact with each other and a case in which the two members are not in contact with each other and one of the two members is located above or below the other member.

### Light-emitting Device according to Present Disclosure

A light-emitting device 1 according to an embodiment of the present disclosure includes a substrate 10, a light-emitting element 20, a wavelength conversion member 30, a covering member 40, and an adhesive member 50. Each component is described in detail below with reference to the drawings.

### Substrate

The substrate 10 is a member on which the light-emitting element 20 is placed, and includes wirings (not illustrated) for supplying electric power to the light-emitting element 20 from an external power source. Examples of a material of the substrate 10 include a single material selected from ceramics such as aluminum oxide, aluminum nitride, and silicon nitride, resins such as phenolic resins, epoxy resins, polyimide resins, BT resins, and polyphthalamide, metals such as copper and aluminum, and semiconductors formed of, for example, silicon, and composite materials thereof.

An upper surface of the substrate 10 may have a recessed portion, and the light-emitting device 1 may have a structure in which the light-emitting element 20 is placed on a bottom surface defining the recessed portion of the substrate 10. The light-emitting device 1 may have a structure that does not include the substrate 10. For example, the light-emitting device 1 may be a light-emitting device including the light-emitting element 20, a metal member joined with an electrode of the light-emitting element 20, and a covering member covering the light-emitting element 20, and having a structure in which a part of the metal member that is exposed and not covered with the covering member serves as an electrode of the light-emitting device. Alternatively, the metal member may not be provided, and an electrode of the light-emitting element 20 may be exposed and not covered with the covering member to serve as an electrode of the light-emitting device.

### Light-emitting Element

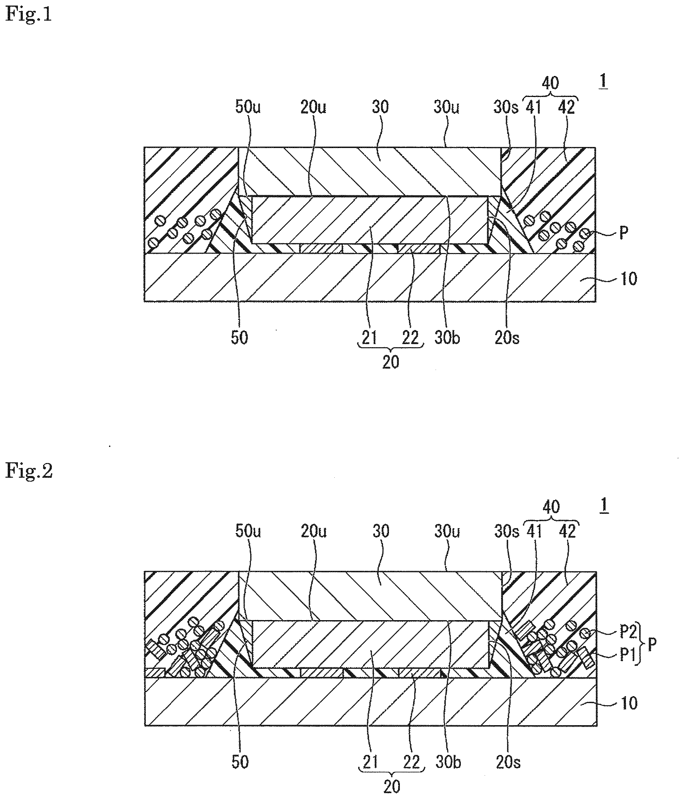

The light-emitting element 20 emits a first light. The first light has a peak wavelength in a range from 380 nm to 470 nm, for example. The first light is, for example, blue light. As illustrated in FIG. 1, the light-emitting element 20 includes a semiconductor layered body 21 and electrodes 22.

The semiconductor layered body 21 includes, for example, a first semiconductor layer, a second semiconductor layer, and a light-emitting layer disposed between the first semiconductor layer and the second semiconductor layer. Examples of the semiconductor layered body 21 include various semiconductors such as an III-V group compound semiconductor and an II-VI group compound semiconductor. More specific examples include a nitride semiconductor material such as In_{X}Al_{Y}Ga_{1 - X - Y}N (0 ≤ X, 0 ≤ Y, X + Y ≤ 1), and InN, AlN, GaN, InGaN, AlGaN, and InGaAlN. With respect to the film thickness and layer structure of each of the layers, a known film thickness and layer structure in this field can be employed. The semiconductor layered body 21 emits the first light from the light-emitting layer.

The light-emitting element 20 includes the electrodes 22 on the semiconductor layered body 21. The electrodes 22 include a first electrode joined with the first semiconductor layer and a second electrode joined with the second semiconductor layer. The first electrode and the second electrode may be disposed on different surfaces of the semiconductor layered body 21 or on the same surface of the semiconductor layered body 21.

A shape of the light-emitting element 20 in a top view is, for example, square or rectangular. The shape of the light-emitting element 20 in a top view may be a polygon such as a triangle or a hexagon.

### Wavelength Conversion Member

The wavelength conversion member 30 is disposed on the light-emitting element 20. The wavelength conversion member 30 includes a lower surface 30b joined to the light-emitting element 20, an upper surface 30u opposite to the lower surface 30b, and lateral surface(s) 30s continuous with the upper surface 30u. The lower surface 30b of the wavelength conversion member 30 is joined to an upper surface 20u of the light-emitting element 20. The lower surface 30b of the wavelength conversion member 30 may be joined to an upper surface 50u of the adhesive member 50. The wavelength conversion member 30 is excited by the first light emitted from the light-emitting element 20 and emits a second light having a peak wavelength longer than the peak wavelength of the first light. The wavelength conversion member 30 is, for example, a member having a flat plate shape. The upper surface 30u and the lower surface 30b are flat surfaces parallel to each other, and the upper surface 30u has a rectangular shape. The lower surface 30b covers the entire upper surface 20u of the light-emitting element 20. The number of the lateral surface(s) 30s can be plural. Specifically, the lateral surface 30s includes four lateral surfaces each continuous with a corresponding side of the upper surface 30u having a rectangular shape. Each of the four lateral surfaces is a plane perpendicular to the upper surface 30u.

The shape of the wavelength conversion member 30 described above is merely an example. For example, in the wavelength conversion member 30, the upper surface 30u and the lower surface 30b may be flat surfaces having the same area, or one of the upper surface 30u and the lower surface 30b may have a shape encompassing the other of a smaller shape in a plan view. In this case, a structure including a step between the upper surface 30u and the lower surface 30b or a lateral surface may include an inclined surface inclined from the upper surface toward the lower surface.

The wavelength conversion member 30 can be joined to the upper surface 20u of the light-emitting element 20 via a light-transmissive bonding member, for example. Alternatively, the wavelength conversion member 30 and the light-emitting element 20 may be directly joined to each other without a bonding member interposed therebetween. The upper surface 30u of the wavelength conversion member 30 is exposed and not covered with the covering member 40 and can constitute a part of an upper surface of the light-emitting device 1. In this case, the upper surface 30u of the wavelength conversion member 30 serves as a luminous surface of the light-emitting device 1.

The wavelength conversion member 30 includes a phosphor that is excited by the first light emitted from the light-emitting element 20 and emits the second light. The peak wavelength of the second light is longer than the peak wavelength of the first light. The peak wavelength of the second light is in a range from 520 nm to 560 nm, for example. For example, the second light is yellow-green to yellow light.

Examples of the wavelength conversion member 30 include a sintered compact of a phosphor, a resin, glass, ceramic, or another inorganic material containing phosphor powder. The wavelength conversion member 30 may be one in which a layer containing a phosphor is disposed on the surface of a formed body of a resin, glass, ceramic, or the like. The wavelength conversion member 30 may contain a filler such as a diffusing material to the extent that the wavelength conversion member 30 does not block light. Examples of the diffusing material that can be used include titanium oxide, silicon oxide, aluminum oxide, and zinc oxide. When a resin is used as a binder for the phosphor or diffusing material, examples of the resin that can be used include resins such as an epoxy resin, a modified epoxy resin, a silicone resin, a modified silicone resin, an acrylic resin, and a fluororesin. The wavelength conversion member 30 can transmit light, and the transmittance with respect to the first light emitted from the light-emitting element 20, the second light subjected to wavelength conversion, and a third light (described below) is preferably 50% or more, more preferably 70% or more.

As the phosphor contained in the wavelength conversion member 30, a phosphor that can be excited by the first light emitted from the light-emitting element 20 is used.

Examples of phosphors that emit green light include an yttrium-aluminum-garnet-based phosphor (e.g., Y₃(Al,Ga)₅O₁₂:Ce), a lutetium-aluminum-garnet-based phosphor (e.g., Lu₃(Al,Ga)₅O₁₂:Ce), a terbium-aluminum-garnet-based phosphor (e.g., Tb₃(Al,Ga)₅O₁₂:Ce), a silicate-based phosphor (e.g., (Ba,Sr)₂SiO₄:Eu), a chlorosilicate-based phosphor (e.g., Ca₈Mg(SiO₄)₄Cl₂:Eu), a β-SiAlON-based phosphor (e.g., (Si,Al)₃(O,N)₄:Eu), and an LSN-based phosphor (e.g., (La,Y)₃Si₆N₁₁:Ce).

Examples of phosphors that emit yellow light include oxynitride phosphors such as α-SiAlON phosphors (e.g., Ca(Si,Al)₁₂(O,N)₁₆:Eu). The above phosphors that emit green light also include a phosphor that emits yellow light. For example, a rare earth aluminate phosphor containing Gd is included. More specifically, when Y is partially substituted with Gd in the yttrium-aluminum-garnet-based phosphor, a light emission peak wavelength can be shifted to a longer wavelength side, so that the yttrium-aluminum-garnet-based phosphor can emit yellow light. Further, the above phosphors include a phosphor that can emit orange light.

Examples of phosphors that emit red light include nitrogen-based phosphors such as a nitrogen-containing calcium aluminosilicate (CASN or SCASN)-based phosphor (e.g., (Sr,Ca)AlSiN₃:Eu) a BSESN-based phosphor (e.g., (Ba,Sr,Ca)₂Si₅N₈:Eu), and an SLA-based phosphor (e.g., SrLiAl₃N₄:Eu). Examples of the phosphors that emit red light also include fluoride-based phosphors such as a KSF-based phosphor (e.g., K₂SiF₆:Mn), a KSAF-based phosphor (e.g., K₂(Si_{1 - x}Alₓ)F_{6 - x}:Mn, where x satisfies 0 < x < 1), and an MGF-based phosphor (e.g., 3.5MgO·0.5MgF₂·GeO₂:Mn).

The KSAF-based phosphor may have a composition represented by the following Formula (A).

M₂[SiₚAl_{q}MnᵣFₛ] (A)

In Formula (A), M represents an alkali metal and may include at least K. Mn may be a tetravalent Mn ion. p, q, r, and s may satisfy 0.9 ≤ p + q + r ≤ 1.1, 0 < q ≤ 0.1, 0 < r ≤ 0.2, and 5.9 ≤ s ≤ 6.1. Preferably, 0.95 ≤ p + q + r ≤ 1.05 or 0.97 ≤ p + q + r ≤ 1.03, 0 < q ≤ 0.03, 0.002 ≤ q ≤ 0.02 or 0.003 ≤ q ≤ 0.015, 0.005 ≤ r ≤ 0.15, 0.01 ≤ r ≤ 0.12 or 0.015 ≤ r ≤ 0.1, 5.92 ≤ s ≤ 6.05 or 5.95 ≤ s ≤ 6.025. Examples of the composition represented by Formula (A) include compositions represented by K₂[Si_{0.946}Al_{0.005}Mn_{0.049}F_{5.995}], K₂[Si_{0.942}Al_{0.008}Mn_{0.050}F_{5.992}], and K₂[Si_{0.939}Al_{0.014}Mn_{0.047}F_{5.986}]. Such a KSAF-based phosphor can emit red light having a high luminance and a narrow half-value width of the light emission peak wavelength.

Among these phosphors, as the phosphor contained in the wavelength conversion member 30, a phosphor containing a rare earth aluminate phosphor having a composition represented by the following Formula (I) can be suitably used as a yellow light-emitting phosphor.

(Ln_{z}Gd_{1-z})₃(AlₓGa₁₋ₓ)₅°₁₂: Ce (I)

(In Formula (I) above, Ln represents one or more elements selected from the group consisting of Y, La, Lu, and Tb, and satisfies 0.84 ≤ z < 1, 0 < x ≤ 1)

More preferably, the proportion of Gd to the total 100 mol% of all elements constituting Ln and Gd may be in a range from 11 mol% to 13 mol%.

In the light-emitting device of the present disclosure, as described below, the covering member 40 contains phosphors P that are excited by the first light and emits the third light. The phosphors P in the covering member 40 can make it possible to adjust a chromaticity of lights emitted from the light-emitting device 1 to a desired chromaticity. For that reason, the amount of material for adjusting the chromaticity in the wavelength conversion member 30 can be reduced. Specifically, the proportion of Gd to the total 100 mol% of all the elements constituting Ln and Gd in the wavelength conversion member 30 can be reduced to the range from 11 mol% to 13 mol%. The effect of reducing the proportion of Gd is described in detail with reference to examples (second and third demonstration tests) to be described below.

The wavelength conversion member 30 and the light-emitting element 20 may be adhered to each other by the adhesive member 50.

### Adhesive Member

The adhesive member 50 bonds the light-emitting element 20 and the wavelength conversion member 30 to each other and serves as a light guide member that guides light emitted from lateral surfaces 20s of the light-emitting element 20 toward the wavelength conversion member 30. As the adhesive member 50, a light-transmissive resin material can be used. For example, a resin material whose main component is a thermosetting resin, such as a silicone resin, a silicone modified resin, an epoxy resin, or a phenolic resin, is preferable. The transmittance of the adhesive member 50 with respect to light from the light-emitting element 20 is preferably 70% or more, more preferably 80% or more, even more preferably 90% or more.

The adhesive member 50 has a shape that becomes wider toward the wavelength conversion member 30 side in a cross-sectional view. When light emitted from the light-emitting element 20 enters the adhesive member 50, the light is reflected upward (in the direction of the luminous surface of the light-emitting device 1) by the covering member 40 (an inner covering member 41 or an outer covering member 42) to be described below, and enters the wavelength conversion member 30.

### Covering Member

The covering member 40 is disposed around the light-emitting element 20 and the wavelength conversion member 30 in a top view. The term "cover" as used herein is not limited to a state in which an object to be covered is directly covered with a covering member, and also includes a state in which the object to be covered is covered by the covering member with another element such as an inclusion interposed therebetween. That is, the adhesive member 50 may be interposed between the light-emitting element 20 and the covering member 40.

For the covering member 40, a resin containing a light-reflective material (not illustrated) and the phosphors P is used. As an example of the resin, a resin such as an epoxy resin, a modified epoxy resin, a silicone resin, a modified silicone resin, an acrylic resin, or a fluororesin may be used.

The light-reflective material contained in the covering member 40 may be titanium oxide, aluminum oxide, silicon oxide, zinc oxide, barium carbonate, barium sulfate, boron nitride, aluminum nitride, or a glass filler. When the covering member 40 contains the light-reflective material, the first light emitted from the light-emitting element 20 and the second light emitted from the wavelength conversion member 30 can be efficiently reflected by the covering member 40, thereby increasing the light extraction efficiency of the light-emitting device 1.

The phosphors P contained in the covering member 40 may be a material that is excited by the first light from the light-emitting element 20 and emits the third light having a peak wavelength longer than the peak wavelength of the second light. The third light has a peak wavelength in a range from 600 nm to 660 nm, for example. The third light is, for example, orange to red light. An example of the phosphor P includes a nitride phosphor such as a BSESN phosphor (e.g., (Ba, Sr, Ca)₂Si₅N₈: Eu). The phosphors P contained in the covering member 40 can adjust the chromaticity of lights to be emitted from the light-emitting device 1 by converting the wavelength of light transmitted without being reflected by the light-reflective material described above into the third light and allowing the light to travel toward the wavelength conversion member 30.

In the phosphors P contained in the covering member 40, the content of the phosphor particles positioned higher than the upper surface of the light-emitting element 20 is less than the content of the phosphor particles positioned lower than the upper surface of the light-emitting element 20. The content of the phosphor particles may be measured by observing the cross section of the light-emitting device 1 as illustrated in FIG. 1 and calculating the total area of the phosphor. The total area of the phosphor particles may be measured by performing a known image processing on a cross-sectional image acquired by the cross-sectional observation.

In the light-emitting device of the present disclosure, because the content of the phosphor particles positioned higher than the upper surface 20u of the light-emitting element 20 is less than the content of the phosphor particles positioned lower than the upper surface 20u of the light-emitting element 20, the phosphor P contained in the covering member 40 can be made less visible in a plan view, changes in the appearance color of the light-emitting device can be reduced, and the appearance of the light-emitting device can be improved. As described in detail in an example (first demonstration test) to be described below, by increasing the content of the phosphor particles positioned lower than the upper surface 20u of the light-emitting element 20, light from the phosphor P can be suppressed from leaking from the covering member 40 to the outside, thereby improving the light emission characteristics of the light-emitting device.

As a further specific embodiment of the light-emitting device of the present disclosure, the phosphor P contained in the covering member 40 is not substantially present at a position higher than the upper surface 20u of the light-emitting element 20. According to such a configuration, the phosphor P contained in the covering member 40 can be made further less visible in a plan view, and the appearance of the light-emitting device can be further improved.

As a preferred embodiment of the covering member 40, the covering member 40 may include the inner covering member 41 located on the light-emitting element 20 side and the outer covering member 42 located outside the inner covering member 41.

The inner covering member 41 is disposed on the upper surface of the substrate 10 and covers the adhesive member 50 and a part of the wavelength conversion member 30. A lateral surface of the inner covering member 41 has a shape that becomes wider toward the substrate 10 side in a cross-sectional view. The inner covering member 41 contains no phosphors.

The outer covering member 42 is disposed on the upper surface of the substrate 10 and covers the inner covering member 41 and the wavelength conversion member 30. An interface between the outer covering member 42 and the inner covering member 41 serves as a reflective surface that reflects the first light, the second light, and the third light toward the wavelength conversion member 30 side. In other words, an inner surface of the outer covering member 42 (or an outer surface of the inner covering member 41) may be inclined to reflect light toward the wavelength conversion member 30. In this way, because the covering member 40 includes the inner covering member 41 and the outer covering member 42 and the interface between the inner covering member 41 and the outer covering member 42 serves as a reflective surface, light can be efficiently reflected and the light extraction efficiency of the light-emitting device 1 can be improved.

As a preferable aspect of the phosphor P contained in the covering member 40, the phosphor P may include two types of phosphors, first phosphor P1 and second phosphor P2 substantially positioned above the first phosphor P1, and the particle size of the first phosphor P1 may be larger than the particle size of the second phosphor P2. More specifically, as illustrated in FIG. 2, particles of the first phosphor P1 having the larger particle size are positioned in a higher quantity on the substrate 10 side in the covering member 40 than particles of the second phosphor P2 having the smaller particle size, and the particles of the second phosphor P2 having the smaller particle size are disposed so as to fill gaps between the particles of the first phosphor P1. That is, in a specific implementation, the content of the first phosphor P1 at a first depth from a luminous surface of the light-emitting device 1 is greater than the content of the second phosphor P2 at the first depth, and the content of the first phosphor P1 at a second depth, which is less than the first depth, from the luminous surface is less than the content of the second phosphor P2 at the second depth. The positional relationship between the particles of the first phosphor P1 and the particles of the second phosphor P2 is based on the weight of each phosphor, and is derived from the fact that the first phosphor P1 is more likely to settle down than the second phosphor P2. Generally, a phosphor particle having a larger size has a higher wavelength conversion efficiency. According to that perspective, by disposing the first phosphor P1 at a position where a large amount of light from the light-emitting element 20 is incident, that is, on the lateral side of the light-emitting element 20 and on the substrate 10 side, effective wavelength conversion can be performed. Because the particles of the second phosphor P2 having the smaller particle size enter the spaces between the particles of the first phosphor P1 having the larger particle size, light from the light-emitting element 20 can be suppressed from passing through the gaps between the particles of the first phosphor P1 without being wavelength-converted, so that wavelength conversion can be more effectively performed.

The particle size of the first phosphor P1 may be in a range from 25 µm to 35 µm. The particle size of the second phosphor P2 may be in a range from 5 µm to 15 µm. When the particle size of the first phosphor P1 and the particle size of the second phosphor P2 are in the numerical ranges described above, the particles of the second phosphor P2 can be appropriately disposed in gaps between the particles of the first phosphor P1.

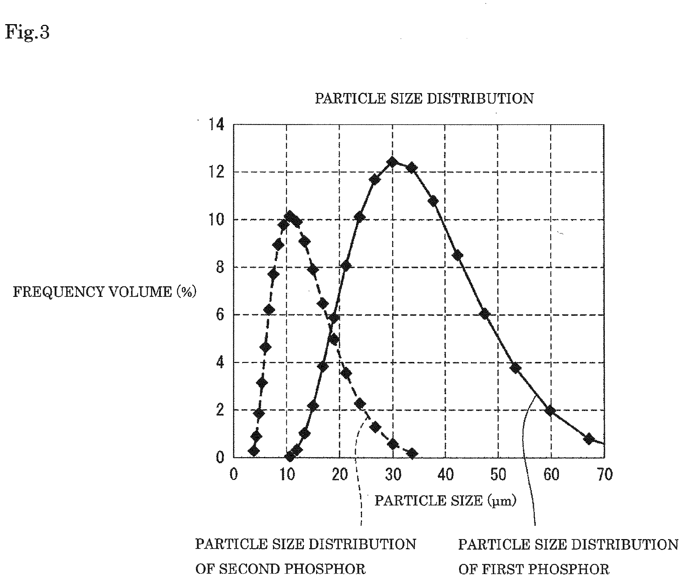

The particle size distribution of the phosphors contained in the covering member 40 may have two or more peaks. As an example, as illustrated in FIG. 3, the particle size distribution may include the particle size distribution of the first phosphor P1 and the particle size distribution of the second phosphor P2 and may have two peaks. By having such peaks, the particles of the second phosphor P2 can be appropriately disposed in the gaps between the particles of the first phosphor P1.

In the particle size distributions illustrated in FIG. 3, the peak value in the particle size distribution having a larger particle size (frequency volume in FIG. 3: about 12.5%) may be higher than the peak value in the particle size distribution having a smaller particle size (frequency volume in FIG. 3: about 10%). Because the peak value in the particle size distribution having the larger particle size is high, light emitted from the light-emitting element 20 is more likely to be irradiated to the phosphor particles having the larger size, and thus the first light can be effectively converted into the third light.

In the particle size distribution of the phosphors contained in the covering member 40, one peak may be present in a particle size range from 5 µm to 15 µm and the other peak may be present in a particle size range from 25 µm to 35 µm. When each peak is present in such particle size ranges, the particles of the second phosphor P2 having the smaller particle size can be appropriately disposed in the gap between the particles of the first phosphor P1 having the larger particle size.

In the above description, the first phosphor P1 and the second phosphor P2 are intended to be different types (that is, two materials of phosphors); however, the present disclosure is not limited to this configuration and one type (that is, one material) of phosphor having different particle sizes may be used.

The content of the phosphor contained in the covering member 40 may be in a range from 10 phr to 30 phr with respect to the entire covering member. When the phosphor P is contained in the covering member 40 within the above numerical range, a color shift is caused by the third light from the phosphor(s) in the covering member with respect to light having a chromaticity generated by the first light from the light-emitting element 20 and the second light converted by the wavelength conversion member 30, and lights from the light-emitting device 1 can be adjusted to have a desired chromaticity.

### Examples

Demonstration tests were conducted on light-emitting devices of the present disclosure as follows.

### First Demonstration Test (Leakage Light Evaluation)

In a first demonstration test, light-emitting devices of Example 1 and Comparative Example 1 to be described below were manufactured, and leakage light of the light-emitting devices was evaluated.

### Premise Configuration (Common Configuration between Example 1 and Comparative Example 1)

The manufactured light-emitting devices include a light-emitting element 20 that emits a light having a light emission peak wavelength in a range from 380 nm to 470 nm, a wavelength conversion member 30 that is disposed on an upper surface of the light-emitting element 20 and emits a light having a light emission peak wavelength in a range from 520 nm to 560 nm, and a covering member 40 that is disposed around the light-emitting element 20 and the wavelength conversion member 30 in a top view and contains a light-reflective material and a phosphor that emits a light having a light emission peak wavelength in a range from 600 nm to 660 nm.

### Example 1

The light-emitting device, in which the content of phosphor particles (of the phosphor P) positioned higher than the upper surface of the light-emitting element 20 is lower than the content of the phosphor particles positioned lower than the upper surface of the light-emitting element 20, was manufactured.

### Comparative Example 1

The light-emitting device in which phosphor particles of the phosphor P are uniformly disposed in the covering member was manufactured. That is, the light-emitting device, in which the content of the phosphor particles positioned higher than the upper surface of the light-emitting element 20 is approximately the same as the content of the phosphor particles positioned lower than the upper surface of the light-emitting element 20, was manufactured.

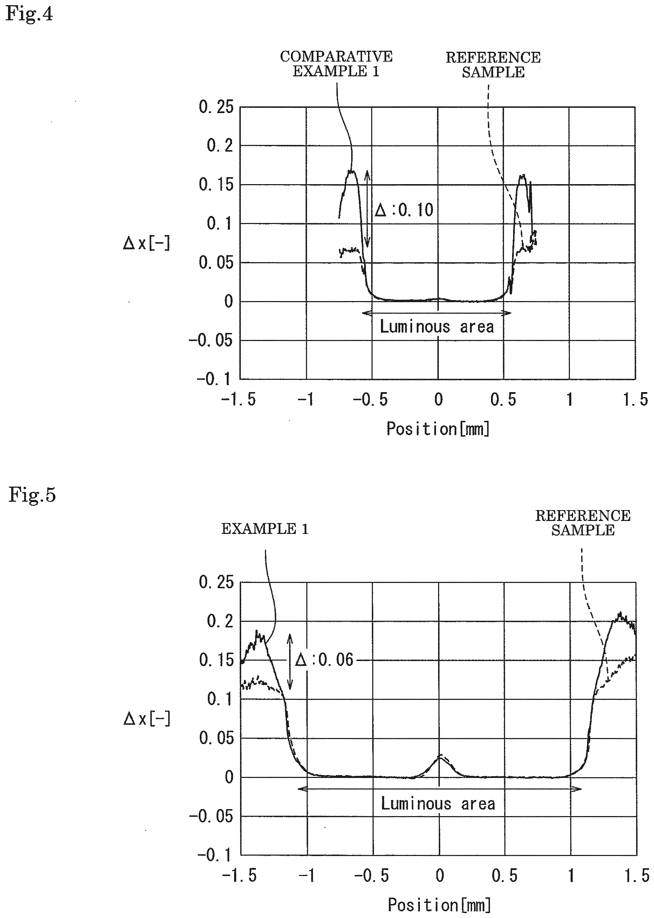

With respect to the light-emitting device of Example 1 and the light-emitting device of Comparative Example 1, leakage light from the phosphor P contained in the covering member 40 outside a luminous surface was evaluated. When evaluating the leakage light, a reference sample, which is a reference for the light-emitting device of Example 1 and the light-emitting device of Comparative Example 1 and does not contain the phosphor P in the covering member 40, was prepared. In the reference sample, because the covering member 40 does not contain the phosphor P, the amount of light emitted from the phosphor P is zero. The measurement results are shown in FIGS. 4 and 5.

As shown in FIG. 4, in the light-emitting device of Comparative Example 1, the difference Δ in the leakage light relative to the reference sample was 0.1. On the other hand, as shown in FIG. 5, in the light-emitting device of Example 1, the difference Δ in the leakage light relative to the reference sample was 0.06. Thus, the leakage light was reduced and the light emission characteristics were improved as compared with the light-emitting device of Comparative Example 1.

### Second Demonstration Test (Temperature Characteristics Evaluation)

In a second demonstration test, a light-emitting device of Example 2 and a light-emitting device of Comparative Example 2 to be described below were manufactured, and temperature characteristics of the light-emitting devices were evaluated.

### Premise Configuration (Common Configuration between Example 2 and Comparative Example 2)

The manufactured light-emitting devices include a light-emitting element that emits a light having a light emission peak wavelength in a range from 380 nm to 470 nm, a wavelength conversion member that is disposed on an upper surface of the light-emitting element and emits a light having a light emission peak wavelength in a range from 520 nm to 560 nm, and a covering member disposed around the light-emitting element and the wavelength conversion member in a top view, the wavelength conversion member containing a rare earth aluminate phosphor having a composition represented by the following Formula (I).

(Ln_{z}Gd_{1 - z})₃(AlₓGa_{1 - x})₅O₁₂: Ce (I)

(In Formula (I) above, Ln represents one or more elements selected from the group consisting of Y, La, Lu, and Tb, and satisfies 0.6 < z < 1, 0 < x ≤ 1)

### Example 2

As illustrated in FIG. 1, the covering member 40 contains a light-reflective material and a phosphor that emits a light having a light emission peak wavelength in a range from 600 nm to 660 nm, and the content of the phosphor particle of the phosphor P positioned higher than the upper surface 20u of the light-emitting element 20 is less than the content of the phosphor particles P positioned lower than the upper surface 20u of the light-emitting element 20.

### Comparative Example 2

Unlike the example described above, the covering member contains no phosphors. The amount of Gd in the wavelength conversion member is larger than the amount of Gd in the example.

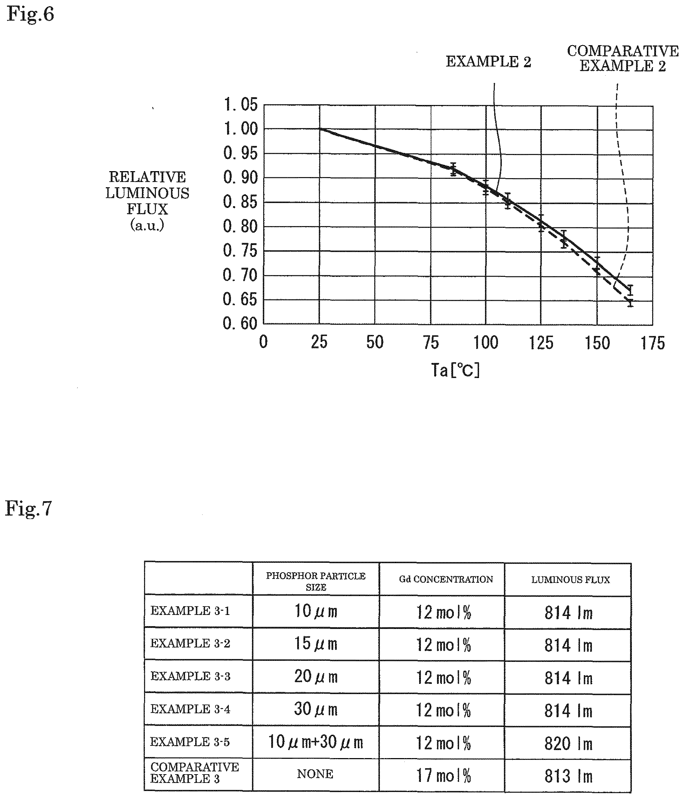

For the light-emitting device of Example 2 and the light-emitting device of Comparative Example 2, the temperature characteristics with respect to the luminous flux of the light-emitting device were evaluated. The measurement results are shown in FIG. 6. As shown in FIG. 6, the light-emitting device of Example 2 had better luminous flux characteristics at a high temperature (40°C or higher) than the light-emitting device of Comparative Example 2. That is, in Example 2, the temperature characteristics could be improved by reducing the amount of Gd over that in Comparative Example 2.

### Third Demonstration Test (Luminous Flux Evaluation for Phosphor Particle Size)

In a third demonstration test, light-emitting devices of Examples 3-1 to 3-5 and a light-emitting device of Comparative Example 3 to be described below were manufactured, and luminous flux evaluation for phosphor particle size was performed on the light-emitting devices.

### Premise Configuration (Common Configuration between Examples 3-1 to 3-5 and Comparative Example 3)

The manufactured light-emitting devices include a light-emitting element that emits a light having a light emission peak wavelength in a range from 380 nm to 470 nm, a wavelength conversion member that is disposed on an upper surface of the light-emitting element and emits a light having a light emission peak wavelength in a range from 520 nm to 560 nm, and a covering member disposed around the light-emitting element and the wavelength conversion member in a top view, the wavelength conversion member containing a rare earth aluminate phosphor having a composition represented by the following Formula (I).

(Ln_{z}Gd_{1 - z})₃(AlₓGa_{1 - x})₅O₁₂: Ce (I)

(In Formula (I) above, Ln represents one or more elements selected from the group consisting of Y, La, Lu, and Tb, and satisfies 0.6 < z < 1, 0 < x ≤ 1)

### Example 3-1

As illustrated in FIG. 1, the light-emitting device includes the covering member 40 containing a light-reflective material and a phosphor P that emits a light having a light emission peak wavelength in a range from 600 nm to 660 nm, the content of the phosphor particles of the phosphor P positioned higher than the upper surface 20u of the light-emitting element 20 is less than the content of the phosphor particles positioned lower than the upper surface 20u of the light-emitting element 20, and a particle size distribution of the phosphor P is such that the peak particle size of the phosphor P is 10 µm.

In the wavelength conversion member 30, the proportion of Gd to the total 100 mol% of all the elements constituting Ln and Gd is 12 mol% or less.

The content of the phosphor P contained in the covering member 40 was adjusted in a range from 10 phr to 30 phr with respect to the entire covering member such that a chromaticity Y of the light-emitting device was 0.340.

### Example 3-2

An aspect different from the configuration of Example 3-1 is a particle size distribution in which the peak particle size of the phosphor P is 15 µm.

### Example 3-3

An aspect different from the configuration of Example 3-1 is a particle size distribution in which the peak particle size of the phosphor P is 20 µm.

### Example 3-4

An aspect different from the configuration of Example 3-1 is a particle size distribution in which the peak particle size of the phosphor P is 30 µm.

### Example 3-5

An aspect different from the configuration of Example 3-1 is that the configuration of Example 3-5 has two peaks of a particle size distribution in which the peak particle size of the phosphor is 10 µm and a particle size distribution in which the peak particle size is 30 µm.

### Comparative Example 3

Unlike the examples described above, the covering member 40 contains no phosphors. In the wavelength conversion member, the proportion of Gd to the total 100 mol% of all the elements constituting Ln and Gd is 17 mol% or less.

The luminous fluxes of the light-emitting devices of Examples 3-1 to 3-5 and the light-emitting device of Comparative Example 3 were evaluated. In evaluating the luminous flux, the chromaticity Y of the light-emitting devices was set to 0.340. The measurement results are shown in FIG. 7. As shown in FIG. 7, the luminous flux of the light-emitting device of Comparative Example 3 was 813 (lm), whereas the luminous fluxes of the light-emitting devices of Examples 3-1 to 3-5 were higher than the luminous flux in Comparative Example. In particular, as in the light-emitting device of Example 3-5, when the particle size distribution of the phosphors had one peak in a particle size range from 5 µm to 15 µm and the other peak in a particle size range from 25 µm to 35 µm, higher luminous flux was obtained.

The embodiments disclosed herein are illustrative in all respects and are not intended to be the basis of limiting interpretation. Accordingly, the technical scope of the present disclosure is not construed solely by the embodiments described above but is defined based on the description of the scope of claims. In addition, the technical scope of the present disclosure includes all variations within the meaning and scope equivalent to the scope of claims.

## Claims

1. A light-emitting device comprising:
a light-emitting element configured to emit a first light;
a wavelength conversion member disposed on an upper surface of the light-emitting element and configured to emit, by excitation by the first light, a second light having a peak wavelength longer than a peak wavelength of the first light; and
a covering member disposed around the light-emitting element and the wavelength conversion member and containing a light-reflective material and a phosphor, the phosphor configured to emit, by excitation by the first light, a third light having a peak wavelength longer than the peak wavelength of the second light, wherein
a content of the phosphor positioned higher than the upper surface of the light-emitting element is less than a content of the phosphor positioned lower than the upper surface of the light-emitting element.

2. The light-emitting device according to claim 1, wherein the phosphor is not substantially present at a position higher than the upper surface of the light-emitting element.

3. The light-emitting device according to any of the preceding claims, wherein the peak wavelength of the first light is in a range from 380 nm to 470 nm.

4. The light-emitting device according to claim 3, wherein the peak wavelength of the second light is in a range from 520 nm to 560 nm.

5. The light-emitting device according to claim 4, wherein the peak wavelength of the third light is in a range from 600 nm to 660 nm.

6. The light-emitting device according to any of the preceding claims, wherein
the phosphor comprises a first phosphor and a second phosphor, and
a particle size of the first phosphor is larger than a particle size of the second phosphor.

7. The light-emitting device according to claim 6, wherein
a content of the first phosphor at a first depth from a luminous surface of the light-emitting device is greater than a content of the second phosphor at the first depth from the luminous surface, and
a content of the first phosphor at a second depth from the luminous surface is less than a content of the second phosphor at the second depth from the luminous surface, the second depth being less than the first depth.

8. The light-emitting device according to claim 6, wherein the particle size of the first phosphor is in a range from 25 µm to 35 µm, and the particle size of the second phosphor is in a range from 5 µm to 15 µm.

9. The light-emitting device according to claim 6, wherein the first phosphor and the second phosphor are made of a same material.

10. The light-emitting device according to claim 6, wherein the first phosphor and the second phosphor are made of different materials.

11. The light-emitting device according to any of the preceding claims, wherein a particle size distribution of the phosphor have two or more peaks.

12. The light-emitting device according to claim 11, wherein, in the peaks, one peak is present in a particle size range from 5 µm to 15 µm and another peak is present in a particle size range from 25 µm to 35 µm.

13. The light-emitting device according to any of the preceding claims, wherein the phosphor is a nitride phosphor.

14. The light-emitting device according to any of the preceding claims, wherein the wavelength conversion member contains a rare earth aluminate phosphor containing Gd.

15. The light-emitting device according to claim 14, wherein the rare earth aluminate phosphor has a composition represented by Formula (I) below:
(Ln_{z}Gd_{1 - z})₃(AlₓGa_{1 - x})₅O₁₂: Ce (I)
(In Formula (I) above, Ln represents one or more elements selected from the group consisting of Y, La, Lu, and Tb, and satisfies 0.84 ≤ z < 1, 0 < x ≤ 1).
